(19) Europäisches Patentamt / European Patent Office / Office européen des brevets

(11) **EP 1 878 153 B1**

(12) **EUROPÄISCHE PATENTSCHRIFT**

(45) Veröffentlichungstag und Bekanntmachung des Hinweises auf die Patenterteilung:
**08.02.2012 Patentblatt 2012/06**

(51) Int Cl.:
*H04L 1/16* $^{(2006.01)}$      *H04L 1/00* $^{(2006.01)}$

(21) Anmeldenummer: **06754993.1**

(22) Anmeldetag: **03.05.2006**

(86) Internationale Anmeldenummer:
**PCT/EP2006/062032**

(87) Internationale Veröffentlichungsnummer:
**WO 2006/117390 (09.11.2006 Gazette 2006/45)**

(54) **VERFAHREN UND VORRICHTUNG ZUM ERMITTELN VON INDIZES DIE KORREKTURSYMBOLEN ZUGEORDNET SIND**

METHOD AND DEVICE FOR DETERMINING INDEXES ALLOCATED TO CORRECTION SYMBOLS

PROCEDE ET DISPOSITIF POUR DETERMINER DES INDICES AFFECTES A DES SYMBOLES DE CORRECTION

(84) Benannte Vertragsstaaten:
**DE FR GB IT SE**

(30) Priorität: **04.05.2005 DE 102005021321
04.05.2005 DE 102005020925
11.05.2005 US 679799 P**

(43) Veröffentlichungstag der Anmeldung:
**16.01.2008 Patentblatt 2008/03**

(73) Patentinhaber: **Siemens Enterprise Communications GmbH & Co. KG
81379 München (DE)**

(72) Erfinder:
• **GASIBA, Tiago
81675 München (DE)**
• **STOCKHAMMER, Thomas
83346 Bergen (DE)**
• **XU, Wen
85579 Neubiberg (DE)**
• **PANDEL, Jürgen
83620 Feldkirchen-Westerham (DE)**

(74) Vertreter: **Fritzsche, Thomas et al
Fritzsche Patent
Naupliastrasse 110
81545 München (DE)**

(56) Entgegenhaltungen:
• **"Raptor code specification for MBMS file download" 3GPP SA4 PSM AD-HOC #31, XX, XX, 21. Mai 2004 (2004-05-21), Seiten 1-8, XP002355055**
• **STOCKHAMMER ET AL: "Raptor Codes for Reliable Download Delivery in Wireless Broadcast Systems" CONSUMER COMMUNICATIONS AND NETWORKING CONFERENCE, 2006. CCNC 2006. 2006 3RD IEEE LAS VEGAS, NV, USA 8-10 JAN. 2006, PISCATAWAY, NJ, USA,IEEE, Januar 2006 (2006-01), Seiten 1-6, XP002367863 ISBN: 1-4244-0085-6**
• **"Universal Mobile Telecommunications System (UMTS); Multimedia Broadcast/Multicast Service (MBMS); user service guidelines" ETSI TR 126 946 V6.0.1, [Online] März 2006 (2006-03), Seiten 1-39, XP002391350 Gefunden im Internet: URL: http://webapp.etsi.org/action/PU/20060 613/tr_ 126946v060001p.pdf> [gefunden am 2006-07-20]**

**Beschreibung**

Die Erfindung betrifft ein Verfahren gemäß dem Oberbegriff des Anspruchs 1, eine Vorrichtung gemäß dem Oberbegriff des Anspruchs 13 und ein Endgerät gemäß dem Oberbegriff des Anspruchs 15.

Bei der Übertragung von Datenpaketen, wie z.B. Audio oder Videodaten, von einem Sender zu einem Empfänger kommt es aufgrund von Übertragungsfehlern zum fehlerhaften Empfang dieser Datenpakete. Insbesondere bei Download-Diensten kann es erforderlich sein, dass alle Datenpakete fehlerfrei am Empfänger rekonstruiert werden können.

Bei MBMS-Diensten (MBMS - Multimedia Broadcast/Multicast Service), die bspw. bei 3GPP (3GPP - Third Generation Partnership Project) standardisiert werden, werden Datenpakete von einem Sender an mehrere Empfänger übertragen. Dabei können bei verschiedenen Empfängern unterschiedliche Datenpakete fehlerhaft den jeweiligen Empfänger erreichen.

Um einen fehlerfreien Empfang zu gewährleisten könnten die Datenpakete mehrfach übertragen werden, so dass ein fehlerhafter Empfang sehr unwahrscheinlich ist. Diese Vorgehensweise ist jedoch äußerst ineffizient, da allen Empfängern, unabhängig ob ein fehlerhafter Empfang vorliegt, die Datenpakete wiederholt zugeschickt werden.

Daneben kann zusätzlich zu den Datenpaketen ein Fehlerschutz in Form von Paritätsdaten an den Empfänger übermittelt werden. Damit kann eine maximale Anzahl von fehlerhaften Datenpaketen korrigiert werden, jedoch kann damit ein fehlerfreier Empfang nicht garantiert werden.

Alternativ oder zusätzlich kann ein Empfänger nach fehlerhaftem Empfang eines oder mehrerer Datenpakete eine Punkt-zu-Punkt Verbindung mit dem Sender aufbauen, um die fehlerhaften Datenpakete im Form von Fehlerkorrekturpaketen anzufordern. Hierbei können alle Datenpakete, die fehlerhaft sind dediziert angefordert werden. Je mehr Datenpakete angefragt werden, desto mehr Bandbreite wird für den MBMS-Dienst benötigt. Ferner steigen mit der Anzahl der angeforderten Datenpakete die Übertragungskosten, da mehr Bandbreite benötigt wird.

Im Allgemeinen kann ein Datenpaket, ein Paritätspaket und/oder ein Fehlerkorrekturpaket aus einem oder mehreren Symbolen gebildet werden. Dabei umfasst ein Datenpaket Quellensymbole, ein Paritätspaket Paritätssymbole und ein Fehlerkorrekturpaket Fehlerkorrektursymbole.

In "Raptor code specification for MBMS file download" 3GPP SA4 PSM AD-HOC #31, XX, XX, 21. Mai 2004 (2004-05-21), Seiten 1-8, ist eine Verwendung eines sogenannten Raptor Blockcodes für die Kanalkodierung von Quellensymbolen beschrieben, welche im Rahmen eines Multimedia Broadcast/Multicast Service-Dienstes an mehrere mobile Empfänger übertragen werden.

In STOCKHAMMER ET AL: "Raptor Codes for Reliable Download Delivery in Wireless Broadcast Systems" CONSUMER COMMUNICATIONS AND NETWORKING CONFERENCE, 2006. CCNC 2006. 2006 3RD IEEE LAS VEGAS, NV, USA 8-10 JAN. 2006, PISCATAWAY, NJ, USA,IEEE, Januar 2006 (2006-01), Seiten 1-6, ISBN: 1-4244-0085-6, ist beschrieben, wie aus einem inhärent nicht-systematischen Raptorcode durch Vorschaltung eines systematischen Block-Vorkodierers ein systematischer Raptorcode erzeugt werden kann.

In "Universal Mobile Telecommunications System (UMTS); Multimedia Broadcast/Multicast Service (MBMS); user service guidelines" ETSI TR 126 946 V6.0.1, [Online] März 2006 (2006-03), Seiten 1-39, URL: http://webapp.etsi.org/action/PU/ 20060613/tr_126946v060001p.pdf>, ist ein Algorithmus beschrieben, der es erlaubt, die minimal benötigte Anzahl von erneut zu sendenden Fehlerkorrektursymbolen zur erfolgreichen Dekodierung einer vorgegebenen Anzahl von Quellensymbolen mittels maximaler Gauß-Elimination (Maximum Gaussian elimination) zu bestimmen

Der Erfindung liegt die Aufgabe zugrunde, ein Verfahren und eine Vorrichtung anzugeben, das/die eine vereinfachte und effektivere Auswahl von Fehlerkorrektursymbolen zur fehlerfreien Rekonstruktion von Quellensymbolen ermöglicht.

Diese Aufgabe wird durch die unabhängigen Ansprüche gelöst.

Hierbei ermöglicht das erfindungsgemäße Verfahren die Ermittlung einer Anzahl an, in einem Block zusammenhängenden, Fehlerkorrektursymbolen, die zur fehlerfreien Rekonstruktion der Quellensymbole benötigt werden. Dabei wird die für die Anforderung zur Übertragung der Fehlerkorrektursymbole benötigte Bandbreite reduziert, da, unabhängig von der Anzahl der benötigten Fehlerkorrektursymbole, lediglich zwei Parameter von der Empfangsvorrichtung an die Sendevorrichtung übertragen werden. Hierdurch wird durch eine Reduktion der Übertragungszeit erzielt, da bei realen Übertragungssystemen ist die Übertragungsbandbreite limitiert.

Sonstige Weiterbildungen der Erfindung sind in den Unteransprüchen wiedergegeben.

In einer bevorzugten Ausgestaltung gemäß den Ansprüchen 4 und 5 lässt sich eine minimierte Anzahl an Indizes und an zugeordneten Fehlerkorrektursymbolen ermitteln, wodurch Übertragungskosten eingespart werden können, da eine lediglich geringe Anzahl von Fehlerkorrektursymbolen übertragen werden muss.

Vorzugweise wird gemäß Anspruch 6 eine Anwendung des erfindungsgemäßen Verfahrens auf eine Verkettung eines systematischen und eines nicht-systematischen Blockcodes erzielt. Dies wird durch Erstellen einer von der systematischen und nicht-systematischen Generatormatrix abgeleiteten Codematrix erreicht, wobei das Ableiten durch einfache Kopieroperationen umgesetzt werden kann.

Ferner wird in einer vorteilhaften Variante des erfindungsgemäßen Verfahrens gemäß Anspruch 7 eine Anwendung für zwei systematische und einen nachgeschalteten nicht-systematischen Blockcode durchgeführt. Dabei kann in besonders einfacher Weise eine Codiermatrix erzeugt werden, wobei das Erzeugen ohne komplexe Matrixoperationen ausgeführt werden kann.

In einer zweckmäßigen Erweiterung des erfindungsgemäßen Verfahrens gemäß Anspruch 8 oder 9 kann das Verfahren auf einen nicht-systematischen oder einen systematischen Raptorcode angewandt werden. Dabei können die äußeren Codes und der innere Code auf zwei systematische und einen nicht-systematischen Blockcode überführt werden, wodurch sich eine einfache Ermittlung der Codiermatrix erreichen lässt. Bei Verwendung eines systematischen Raptorcode muss vor Anwendung eines systematischen Blockcodes eine Korrekturmatrix eines nicht-systematischen Blockcodes eingefügt werden, wobei diese Korrekturmatrix bei der Erstellung der Codiermatrix unberücksichtigt bleibt.

Vorzugsweise wird das erfindungsgemäße Verfahren mit einem systematischen oder nicht-systematischen Blockcode gemäß Anspruch 10 oder 11 verwendet. Dabei kann die Codiermatrix in besonders einfacher Weise durch Kopieren der Generatormatrix generiert werden.

Vorzugsweise werden den Quellensymbolen, codierten Codesymbolen und den Codesymbolen binäre Werte oder Werte eines Galois-Felds zugewiesen. Dadurch ist das erfindungsgemäße Verfahren bei unterschiedlichen Zahlenräumen und somit für eine Vielzahl unterschiedlicher Applikationen einsetzbar.

Die Erfindung betrifft auch eine Vorrichtung zum Durchführen des erfindungsgemäßen Verfahrens und der dazu abhängigen Unteransprüche. Somit kann das erfindungsgemäße Verfahren in einem Gerät, insbesondere einem tragbaren Mobilfunkgerät, implementiert und ausgeführt werden.

Die Erfindung und ihre Weiterbildungen werden nachfolgend anhand von Figuren näher erläutert.

Es zeigen:

Figur 1     ein Ausführungsbeispiel des erfindungsgemäßen Verfahrens mit einer Sende- und Empfangsvorrichtung und einem fehlerbehafteten Übertragungskanals;

Figur 2     ein Ablaufdiagramm des erfindungsgemäßen Verfahrens;

Figur 3     eine erste Variante des erfindungsgemäßen Verfahrens mit einem systematischen und einem nichtsystematischen Blockcode;

Figur 4     eine Generatormatrix gemäß der ersten Variante;

Figur 5     eine zweite Variante des erfindungsgemäßen Verfahrens mit zwei systematischen und einem nichtsystematischen Blockcode;

Figur 6     eine Generatormatrix gemäß der zweiten Variante;

Figur 7     Anwendung einer erfindungsgemäßen Vorrichtung in einem tragbaren Gerät.

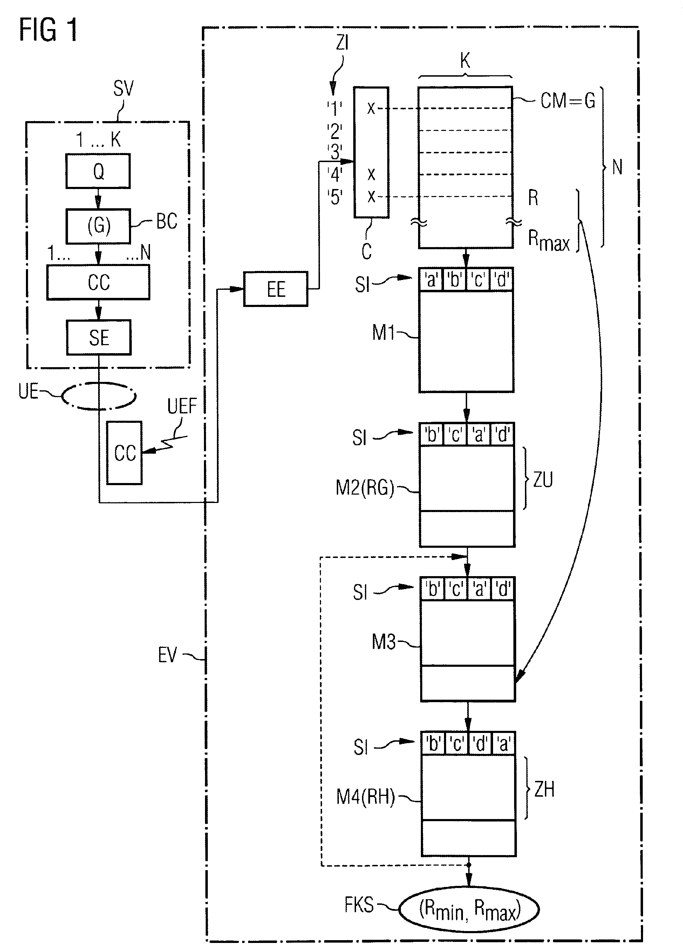

Elemente mit gleicher Funktion und Wirkungsweise sind in den Figuren 1 mit 7 mit denselben Bezugszeichen versehen.

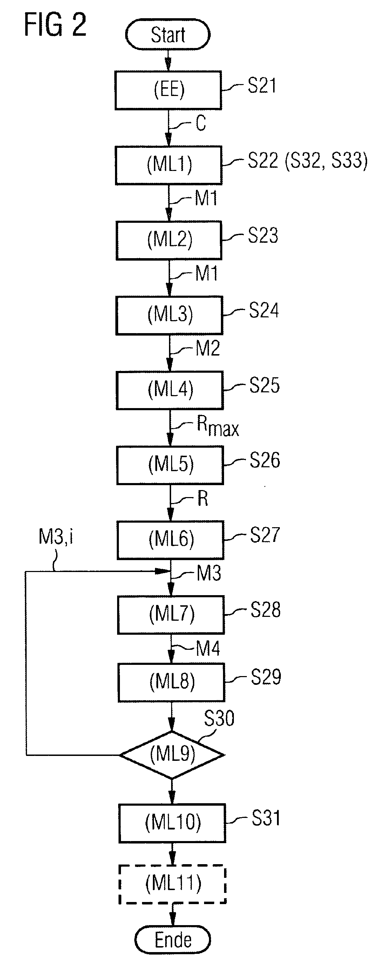

Mit Hilfe der Figuren 1 und 2 wird das erfindungsgemäße Verfahren näher erläutert. In Figur 1 ist eine Sendevorrichtung SV, bspw. eine MBMS-Sendevorrichtung (MBMS - Multimedia Broadcast/Multicast Service), zu sehen. Diese Sendevorrichtung SV codiert mit Hilfe einer Generatormatrix G eines Blockcodes BCN Quellensymbole Q der Anzahl K. Diese Quellensymbole Q repräsentieren bspw. eine komprimierte Sprach- oder Bilddatei. So sind die komprimierte Sprachdatei z.B. nach AMR-Standard (AMR - Adaptive Multirate) und die komprimierte Bilddatei nach JPEG-Standard (JPEG - Joint Picture Expert Group) codiert worden. Die Quellensymbole Q können im Allgemeinen beliebige Daten beschreiben, welche komprimiert oder nicht komprimiert sein können. Für die weitere Ausführung wird die Vektor- bzw. Matrixschreibweise benutzt.

Für das folgende Ausführungsbeispiel werden binäre Quellensymbole Q verwendet, wie bspw.

$$Q = \begin{bmatrix} 1 & 1 & 0 & 1 \end{bmatrix}^T , \qquad\qquad (1)$$

wobei eine erste Anzahl K an Quellensymbole K=4 beträgt.

Die Generatormatrix G kann folgendermaßen wiedergegeben werden:

3

$$G = \begin{bmatrix} 1 & 0 & 0 & 0 \\ 0 & 1 & 0 & 0 \\ 0 & 0 & 1 & 0 \\ 0 & 0 & 0 & 1 \\ 0 & 1 & 1 & 1 \\ 1 & 0 & 1 & 1 \\ 1 & 1 & 0 & 1 \\ \vdots & \vdots & \vdots & \vdots \end{bmatrix} \begin{matrix} '1' \\ '2' \\ '3' \\ '4' \\ '5' \\ '6' \\ '7' \\ ':' \end{matrix} \Big\} N \qquad\qquad (2)$$

In der Generatormatrix G sind natürliche Zahlen zur Beschreibung der Zeilenindizes verwendet worden. Im Allgemeinen sind als Zeilenindex Markierungen zu verwenden, die eine eindeutige Identifikation der markierten Zeile erlauben. Neben natürlichen Zahlen können z.B. auch Buchstaben oder Speicheradressen benutzt werden.

Durch diese Generatormatrix G können aus K=4 Quellensymbole Q N codierte Codesymbole CC gebildet werden. Da diese Generatormatrix G einen systematischen Blockcode BC beschreibt sind K=4 codierte Codesymbole CC identisch mit den K=4 Quellensymbolen Q und die restlichen N-K codierten Codesymbole CC entsprechen Paritätssymbolen P. Das Bezugszeichen N wird als zweite Anzahl N bezeichnet. Die codierten Codesymbole CC berechnen sich zu:

$$CC = G \times Q = [1,1,0,1,0,0,1,\cdots]^T \qquad\qquad (3)$$

Nun wird eine dritte Anzahl N' an codierten Codesymbolen CC übertragen, wobei die dritte Anzahl N' kleiner oder gleich der zweiten Anzahl N ist. Beispielsweise werden die ersten N'=5 codierten Codesymbole übertragen:

$$CC = [1,1,0,1,0]^T \qquad\qquad (4)$$

Bei der Übertragung der codierten Codesymbole CC von einer Sendeeinheit SE der Sendevorrichtung SV über einen Übertragungskanal UE zu einer Empfangseinheit EE einer Empfangsvorrichtung EV treten Übertragungsfehler UEF auf. Die Empfangsvorrichtung EV kann als MBMS-Empfangsstation ausgebildet sein. Insbesondere bei Übertragung über drahtlose Übertragungskänale UE, z.B. über einen nach GSM-Standard (GSM - Global System for Mobile Communications) oder UMTS-Standard (UMTS - Universal Mobile Telecommunications System) arbeitenden Mobilfunkkanal, treten Übertragungsfehler UEF zu Tage. Ferner können auch bei drahtgebundenen Übertragungswegen Fehler auftreten, wie z.B. bei IP über LAN (IP - Internet Protocol, LAN - Local Area Betwork). Dabei können codierte Codesymbole CC verfälscht empfangen werden, oder codierte Codesymbole CC werden bei der Übertragung ausgelöscht und erreichen die Empfangseinheit EE nicht oder erreichen die Empfangseinheit EE in einer vertauschten Reihenfolge. Bei der vorliegenden Erfindung erreichen codierte Codesymbole CC die Empfangsvorrichtung EV als fehlerhaft empfangene Codesymbole C. In Figur 1 sind empfangene Codesymbole C, die z.B. aufgrund einer Verfälschung, Auslöschung oder Vertauschung fehlerhaft sind, mit einem Bezugszeichen 'X' markiert. In Figur 2 ist der Empfang der Codesymbole C im Schritt S21 wiedergegeben.

Im vorliegenden Ausführungsbeispiel zeigen die empfangenen Codesymbole C folgendes Aussehen, wobei von der zweiten Anzahl N an codierten Codesymbolen CC nicht alle übertragen worden sind, sondern nur ein Teil davon:

$$C = [X,1,0,X,X]^T \qquad\qquad (5)$$

Somit sind die Codesymbole C mit einem Index 2 und 3 empfangen bzw. mit dem Index 1, 4 und 5 nicht empfangen worden. Das Codesymbol C mit dem Index 5 kann während der Übertragung ausgelöscht worden sein. Die Empfangsvorrichtung EV hat keine Kenntnis, ob das Codesymbol C mit dem Index 5 gesendet wurde oder nicht. Der Empfangsvorrichtung sind damit nur die Codesymbole mit den Indizes 2 und 3 bekannt. Der Index gibt eine Position des Codesymbols innerhalb des durch alle Codesymbole aufgespannten Zeilenvektors an, z.B. ist der Index 2 das zweite Codesymbol mit einem Wert '1' und der Index fünf zeigt auf das letzte Codesymbol mit einem Wert 'X'. In diesem Ausführungsbeispiel werden binäre Symbole mit den Zeichen '0' und '1' für die Quellensymbole Q, codierten Codesymbole CC, Codiersymbole C und die Koeffizienten der Matrizen benutzt.

In einem weiteren Verarbeitungsschritt S22 wird der größte Index aller empfangenen Codesymbole C ermittelt. Dies ist im vorliegenden Ausführungsbeispiel der Index '3'. Im Anschluss daran wird einem ersten Parameter Rmin ein Wert zugewiesen, der größer als der Index des letzten empfangenen Index ist. Rmin wird beispielsweise zu Rmin = 4 gesetzt, wobei auch ein größerer Wert gewählt werden kann.

In einem weiteren Verarbeitungsschritt S23 wird eine erste Matrix M1 aus einer von der Generatormatrix G abgeleiteten Codiermatrix CM gebildet. Die Codiermatrix CM ist bei einem systematischen und/oder nicht systematischen Blockcode BC die dazugehörige Generatormatrix G. Unter dem Begriff nicht-systematischer Blockcode können im Rahmen dieser Erfindung auch systematische Blockcodes verstanden werden. Als Blockcode werden bspw. ein LDGM-Code oder ein LPDC-Code (LDGM - Low Density Generator Matrix, LDPC - Low Density Parity Code) benutzt. Die Codiermatrix CM für nacheinander ausgeführte Blockcodes wird in einer Ausführungsvariante erläutert. Da es sich bei diesem Ausführungsbeispiel um einen systematischen Blockcode BC handelt ist die Codiermatrix CM identisch zur Generatormatrix in (2).

Die erste Matrix M1 wird aus der Codiermatrix CM durch zeilenweises Kopieren der i-ten Zeile für fehlerfrei empfangene i-te Codiersymbole C erzeugt. Somit werden Zeilen ZX mit einer Zeilennummer 2 und 3 der Codiermatrix CM in die erste Matrix M1 kopiert, d.h. die Codesymbole C mit dem Index 2 und 3 fehlerfrei empfangen worden sind. Somit ergibt sich die erste Matrix M1 zu

$$M1 = \begin{bmatrix} 0 & 1 & 0 & 0 \\ 0 & 0 & 1 & 0 \end{bmatrix} \qquad (6)$$

Hierbei wird jede der Spalten im Schritt S24 mit einem Spaltenindex markiert, wobei der jeweilige Spaltenindex SI der Spaltennummer der Generatormatrix GN entspricht. Zur Unterscheidung zwischen Koeffizient und Spaltenindex SI wird der jeweilige Zeilenindex SI in Anführungszeichen gesetzt. So ist die Spalte 1 mit dem Index 'a', die Spalte 2 mit dem Index 'b', Spalte 3 mit dem Index 'c', usw. markiert. Die markierte zweite Matrix M2 lautet somit:

$$M1 = \begin{matrix} 'a' & 'b' & 'c' & 'd' \\ \begin{bmatrix} 0 & 1 & 0 & 0 \\ 0 & 0 & 1 & 0 \end{bmatrix} \end{matrix} \qquad (7)$$

In der ersten Matrix M1 sind Buchstaben zur Beschreibung der Spaltenindizes verwendet worden. Im Allgemeinen sind als Spaltenindex Markierungen zu verwenden, die eine eindeutige Identifikation der markierten Spalte erlauben. Neben Buchstaben können auch natürliche Zahlen oder Speicheradressen benutzt werden.

In einem weiteren Schritt S25 wird die erste Matrix M1 durch elementare Zeilenumformung und/oder Spaltentausch in eine zweite Matrix M2 transformiert, wobei als Ergebnis RG unabhängige Zeilen ZU entstehen, wobei RG einem Rang der zweiten Matrix M2 entspricht. Unter elementarer Zeilenumformung sind gemäß [1] Seite 61 folgende Operationen bekannt:

   (I) Addition eines Vielfaches einer Zeile zu einer anderen Zeile
   (II) Vertauschen zweier Zeilen
   (III) Multiplikation einer Zeile mit einem Skalar $\lambda \neq 0$

Zur Ermittlung der zweiten Matrix M2 wird zunächst die Matrix M1 kopiert und dann werden folgende Arbeitsschritte durchgeführt, wobei im Folgenden für jeden Arbeitsschritt das Zwischenergebnis der zweiten Matrix M2 angegeben ist:

a) Vertauschen der Spalte mit dem Index 'a' und Spalte mit dem Index 'b':

$$M2 = \begin{matrix} 'b' & 'a' & 'c' & 'd' \\ \begin{bmatrix} 1 & 0 & 0 & 0 \\ 0 & 0 & 1 & 0 \end{bmatrix} \end{matrix} \qquad (8)$$

b) Vertauschen der Spalte mit dem Index 'a' und Spalte mit dem Index 'c':

$$M2 = \begin{matrix} 'b' & 'c' & 'a' & 'd' \\ \begin{bmatrix} 1 & 0 & 0 & 0 \\ 0 & 1 & 0 & 0 \end{bmatrix} \end{matrix} \qquad (9)$$

Hierbei ist der Rang RG(M2)=2 und somit sind in der zweiten Matrix M2 RG Zeilen ZU unabhängig.

In einem weiteren Schritt S26 wird ein zweiter Parameter Rmax nach der Formel

$$\mathrm{Rmax = Rmin + m - 1.} \qquad (10)$$

Bestimmt. Ein in Formel (11) notwendiger dritter Parameter m bestimmt sich nach der Formel

$$\mathrm{m \le L - RG(M2).} \qquad (11)$$

L stellt eine Anzahl an Zwischensymbolen dar, die im Ausführungsbeispiel der Anzahl K an Quellensymbolen Q entspricht: L = 4. Als Zwischensymbole werden die Symbole bezeichnet, die durch Multiplikation mit dem innersten Blockcode die Codesymbole erzeugen. Bei einer Verkettung von Codes sind die Zwischensymbole nicht identisch zu den Quellensymbolen. Der dritte Parameter m ist im Ergebnis eine beliebige natürliche Zahl, die zwischen 1 und der Differenz der Anzahl L an Zwischensymbolen und dem Rang RG der zweiten Matrix M2 ist.

Im Ausführungsbeispiel ergibt sich für Rmax gemäß den Formeln 11 und 12:

$$\mathrm{Rmax \le Rmin + L - RG(M2) - 1 = 4 + 4 - 2 - 1 = 5.}$$

In einem Schritt S27 wird ein vierter Parameter R zu

$$\mathrm{R = Rmin,} \qquad (12)$$

wodurch sich im Ausführungsbeispiel R = 4 ergibt.

Hieran schließt sich in einem Schritt S28 das zeilenweise Bilden einer dritten Matrix M3 an, welche aus der zweiten Matrix M2 und aus der von der Generatormatrix G abgeleiteten Codiermatrix erzeugt wird. Dies erfolgt derart, dass zunächst alle Zeilen der zweiten Matrix M2 in die dritte Matrix M3 kopiert werden und anschließend alle Zeilen zwischen einschließlich der R-ten und einschließlich der Rmax-ten der Codiermatrix CM in die dritte Matrix M3 kopiert werden. Dabei umfasst das Kopieren der Zeilen der Codiermatrix CM die Durchführung der zur Bildung der zweiten Matrix M2 vorgenommenen identischen Spaltenvertauschungen für die zu kopierenden Zeilen. Nachdem im vorliegenden Ausführungsbeispiel R = Rmax = 4 ist, werden die mit dem Index '4' und '5' gekennzeichneten Zeilen der Codiermatrix in die dritte Matrix M3 kopiert.

Dies bedeutet für das vorliegende Ausführungsbeispiel, dass in den mit dem Index '4' und '5' der Codiermatrix gekennzeichnete Zeilen folgende Umformungen vorgenommen werden:

a) Vertauschen der Spalte mit dem Index 'a' und der Spalte mit dem Index 'b';
b) Vertauschen der Spalte mit dem Index 'a' und Spalte mit dem Index 'c';
c) Vertauschen der Spalte mit dem Index 'a' und Spalte mit dem Index 'd'.

Die dritte Matrix ergibt sich dann wie folgt:

$$M3 = \begin{matrix} 'b' & 'c' & 'a' & 'd' \\ \begin{bmatrix} 1 & 0 & 0 & 0 \\ 0 & 1 & 0 & 0 \\ 0 & 0 & 0 & 1 \\ 1 & 1 & 0 & 1 \end{bmatrix} & \begin{matrix} \\ \\ '4' \\ '5' \end{matrix} \end{matrix} \qquad (13)$$

Die dritte Matrix M3 wird in einem Schritt S29 einer elementaren Zeilenumformung und/oder Spaltentausch in eine vierte Matrix M4 transformiert, wobei als Ergebnis RH unabhängige Zeilen ZH entstehen, wobei RH einem Rang der vierten Matrix M4 entspricht.
Zur Ermittlung der vierten Matrix M4 wird zunächst die Matrix M3 kopiert und dann werden folgende Arbeitsschritte durchgeführt, wobei im Folgenden für jeden Arbeitsschritt das Zwischenergebnis der vierten Matrix angegeben ist:

a) Vertauschung der dritten und vierten Spalte:

$$M4 = \begin{matrix} 'b' & 'c' & 'd' & 'a' \\ \begin{bmatrix} 1 & 0 & 0 & 0 \\ 0 & 1 & 0 & 0 \\ 0 & 0 & 1 & 0 \\ 1 & 1 & 1 & 0 \end{bmatrix} \end{matrix} \qquad (14)$$

b) Addition der ersten Zeile zur vierten Zeile:

$$M4 = \begin{matrix} 'b' & 'c' & 'd' & 'a' \\ \begin{bmatrix} 1 & 0 & 0 & 0 \\ 0 & 1 & 0 & 0 \\ 0 & 0 & 1 & 0 \\ 0 & 1 & 1 & 0 \end{bmatrix} \end{matrix} \qquad (15)$$

c) Addition der zweiten Zeile zur vierten Zeile:

'b'  'c'  'd'  'a'

$$M4 = \begin{bmatrix} 1 & 0 & 0 & 0 \\ 0 & 1 & 0 & 0 \\ 0 & 0 & 1 & 0 \\ 0 & 0 & 1 & 0 \end{bmatrix} \qquad (16)$$

d) Addition der dritten Zeile zur vierten Zeile:

'b'  'c'  'd'  'a'

$$M4 = \begin{bmatrix} 1 & 0 & 0 & 0 \\ 0 & 1 & 0 & 0 \\ 0 & 0 & 1 & 0 \\ 0 & 0 & 0 & 0 \end{bmatrix} \qquad (17)$$

Hierbei ist der Rang RH(M4)=3 und somit sind in der vierten Matrix M4 RH Zeilen ZH unabhängig. Eine Überprüfung, ob die vierte Matrix M4 einen vollen Rang besitzt, wird in Schritt S30 durchgeführt. Nachdem die vierte Matrix M4 gemäß (17) noch keinen vollen Rang besitzt, ist eine Fortführung des Algorithmus notwendig.

Damit wird in Schritt S30 der vierte Parameter R zu Rmax gesetzt wird:

$$R = Rmax = 5 \qquad (18)$$

Es wird weiter ein fünfter Parameter n nach der Formel

$$n \leq L - RH(M4). \qquad (19)$$

ermittelt. Weiter wird der zweite Parameter Rmax nach der Formel:

$$Rmax = Rmax + n$$

berechnet. L stellt, wie bereits erläutert, die Anzahl an Zwischensymbolen dar, die im Ausführungsbeispiel der Anzahl K an Quellensymbolen Q entspricht: L = 4. Der fünfte Parameter n ist (wie der dritte Parameter m) eine beliebige natürliche Zahl, die zwischen 1 und der Differenz der Anzahl L an Zwischensymbolen und dem Rang RH der zweiten Matrix M4 ist.

Der fünfte Parameter n beträgt im Ausführungsbeispiel damit n = 1, so dass sich für Rmax gemäß der Formel (19) Rmax = 5 + 1 = 6 ergibt.

Im folgenden werden die Schritte S28 und S29 wiederholt, wobei jedoch an die Stelle der zweiten Matrix M2 die vierte Matrix M4 tritt.

Gemäß der obigen Beschreibung schließt sich in dem Schritt S28 das zeilenweise Bilden einer dritten Matrix M3,1 an, welche aus der vierten Matrix M4 und aus der von der Generatormatrix G abgeleiteten Codiermatrix erzeugt wird. Durch die Schreibweise ",1" im Anschluss an die dritte Matrix M3 ist die erste Iteration (allg. i-te Iteration) des Schrittes S28 angedeutet. Somit werden zunächst alle Zeilen der vierten Matrix M4 in die dritte Matrix M3,1 kopiert, wobei vorab eine Bereinigung der Matrix M4 um Zeilen, deren Koeffizienten mit Null belegt sind, vorgenommen werden kann. Anschließend werden alle Zeilen zwischen einschließlich der R-ten und einschließlich der Rmax-ten der Codiermatrix CM in die dritte Matrix M3,1 kopiert werden. Dabei umfasst das Kopieren der Zeilen der Codiermatrix CM die Durchführung der zur Bildung der zweiten Matrix M2 vorgenommenen identischen Spaltenvertauschungen für die zu kopierenden Zeilen. Nachdem im vorliegenden Ausführungsbeispiel R = Rmax = 6 ist, wird lediglich die mit dem Index '6' gekennzeichnete Zeile der Codiermatrix CM in die dritte Matrix M3,1 kopiert.

Dies bedeutet für das vorliegende Ausführungsbeispiel, dass in der mit dem Index '6' der Codiermatrix gekennzeichneten Zeile folgende Umformungen vorgenommen werden:

a) Vertauschen der Spalte mit dem Index 'a' und der Spalte mit dem Index 'b';
b) Vertauschen der Spalte mit dem Index 'a' und Spalte mit dem Index 'c';
c) Vertauschen der Spalte mit dem Index 'a' und Spalte mit dem Index 'd'.

Die dritte Matrix M3,1 ergibt sich dann wie folgt:

$$M3,1 = \begin{array}{c} \phantom{M}\begin{array}{cccc} 'b' & 'c' & 'd' & 'a' \end{array} \\ \begin{bmatrix} 1 & 0 & 0 & 0 \\ 0 & 1 & 0 & 0 \\ 0 & 0 & 1 & 0 \\ 0 & 1 & 1 & 1 \end{bmatrix}\begin{array}{c} \\ \\ \\ '6' \end{array} \end{array} \qquad (20)$$

Die dritte Matrix M3,1 wird in Schritt S29 einer elementaren Zeilenumformung und/oder Spaltentausch in eine vierte Matrix M4,1 transformiert, wobei als Ergebnis RH unabhängige Zeilen ZH entstehen und RH dem Rang der vierten Matrix M4,1 entspricht.

Zur Ermittlung der vierten Matrix M4,1 wird zunächst die Matrix M3,1 kopiert und dann werden folgende Arbeitsschritte durchgeführt, wobei im Folgenden für jeden Arbeitsschritt das Zwischenergebnis der vierten Matrix angegeben ist:

a) Addition der zweiten Zeile zur vierten Zeile:

$$M4,1 = \begin{array}{c} \begin{array}{cccc} 'b' & 'c' & 'd' & 'a' \end{array} \\ \begin{bmatrix} 1 & 0 & 0 & 0 \\ 0 & 1 & 0 & 0 \\ 0 & 0 & 1 & 0 \\ 0 & 0 & 1 & 1 \end{bmatrix} \end{array} \qquad (21)$$

b) Addition der dritten Zeile zur vierten Zeile:

$$M4,1 = \begin{array}{c} \begin{array}{cccc} 'b' & 'c' & 'd' & 'a' \end{array} \\ \begin{bmatrix} 1 & 0 & 0 & 0 \\ 0 & 1 & 0 & 0 \\ 0 & 0 & 1 & 0 \\ 0 & 0 & 0 & 1 \end{bmatrix} \end{array} \qquad (22)$$

Der Rang RH(M4,1) der vierten Matrix M4,1 ist RH (4,1) = 4, womit die vierte Matrix M4,1 einen vollen Rang besitzt. Dadurch bedingt kann die Iterationsschleife des Schrittes S30 übersprungen und zu einem Schritt S31 übergegangen werden.

Im Schritt S31 werden der erste Parameter Rmin und der zweite Parameter Ramx durch die Empfangseinrichtung EV an die Sendevorrichtung SV übertragen. Durch Rmin und Rmax ist ein Bereich von Indizes von codierten Codesymbolen eindeutig festgelegt, anhand denen ein Bereich zu übertragender Fehlerkorrektursymbole FKS ermittelbar ist. Die Fehlerkorrektursymbole FKS können dann von der Sendevorrichtung SV ermittelt und an die Empfangsvorrichtung EV übertragen werden.

Im vorliegenden Ausführungsbeispiel beträgt Rmin = 4 und Rmax =6, so dass nur drei Fehlerkorrektursymbole FKS angefordert werden. Im Allgemeinen kann eine Vielzahl an Fehlerkorrektursymbolen angefragt werden. Nachdem das Fehlerkorrektursymbol FKS, wie bspw. das codierte Codesymbol CC mit den Indizes 4 und 6, an der Empfangsvorrichtung EV fehlerfrei vorliegt, kann eine vollständige Rekonstruktion der Quellensymbole Q durchgeführt werden. Dazu können das fehlerhafte Codesymbole C durch fehlerfrei empfangene Fehlerkorrektursymbole FKS ersetzt werden. Auf eine Darstellung der Rekonstruktion wird an dieser Stelle verzichtet, da die Rekonstruktion von Quellensymbolen aus Codesymbolen mittels eines Blockcodes bekannt ist.

Wird nur ein Teil der Fehlerkorrektursymbole FKS fehlerfrei empfangen, so kann das erfindungsgemäße Verfahren auf die empfangenen Codesymbole und die empfangenen Fehlerkorrektursymbole angewandt werden, wobei als Ergebnis diejenigen zusätzlichen Fehlerkorrektursymbole gewonnen werden, die zur vollständigen Rekonstruktion der Quellensymbole zusätzlich benötigt werden.

In einer Ausführungsform kann der fünfte Parameter n immer zu 1 gesetzt werden, wodurch unter Umständen eine erhöhte Anzahl an Iterationsschritten S28 und S29 durchzuführen ist. Dabei kann allerdings eine minimale Anzahl an zu ermittelnden Indizes und damit eine minimale Anzahl an zu übertragenden Fehlerkorrektursymbolen ermittelt werden.

Andererseits kann durch einen größeren Wert des fünften Parameters n ein hinreichender, aber nicht minimaler Indexbereich ermittelt werden.

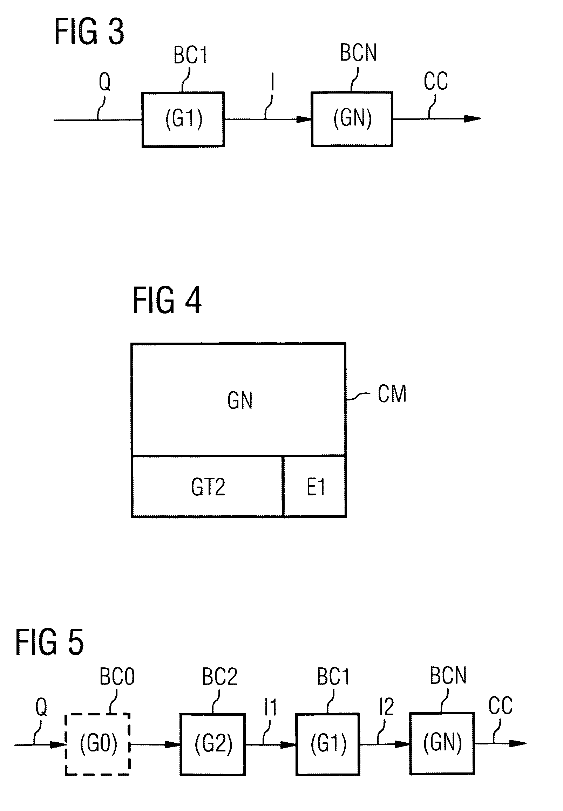

Neben der Verwendung eines einzigen, systematischen oder nicht-systematischen, Blockcodes kann das erfindungsgemäße Verfahren auch bei Anwendung mehrerer, hintereinander geschalteter Blockscodes eingesetzt werden. Im folgenden Ausführungsbeispiel gemäß Figur 3 werden die Quellensymbole Q zuerst mit einer ersten Generatormatrix G1 eines systematischen Blockcode BC1 und die hieraus codierten Symbole I mit einer nicht-systematischen Generatormatrix GN eines nicht-systematischen Blockcodes BCN codiert. Am Ausgang des nicht-systematischen Blockcodes BCN stehen die codierten Codesymbole CC zur Verfügung.

In Figur 4 ist ein Aufbau der Codiermatrix CM zu sehen, wobei zu beachten ist, dass gemäß dieser Erweiterung des erfindungsgemäßen Verfahrens die Codiermatrix CM zur Ermittlung der Fehlerkorrektursymbole FKS und nicht zur Generierung der codierten Codesymbole CC verwendet wird. Die Codiermatrix CM wird nach folgenden Schritten erzeugt:

a) Die nicht-systematische Generatormatrix GN wird zeilenweise in die Codiermatrix CM kopiert. Nach diesem Schritt zeigt die Codiermatrix CM folgendes Aussehen:

$$CM = GN \qquad\qquad (23)$$

b) Die erste Generatormatrix G1 wird in einen ersten Generatorteil GT1, der die systematischen Symbole erzeugt, und in einen zweiten Generatorteil GT2, der die Paritätssymbole P, d.h. die nicht-systematischen Symbole, erstellt, aufgeteilt. Ist die erste Generatormatrix G1 bspw. folgendermaßen aufgebaut,

$$G1 = \begin{bmatrix} 1 & 0 & 0 & 0 \\ 0 & 1 & 0 & 0 \\ 0 & 0 & 1 & 0 \\ 0 & 0 & 0 & 1 \\ 0 & 1 & 1 & 1 \\ 1 & 0 & 1 & 1 \\ 1 & 1 & 0 & 1 \end{bmatrix} \tag{24}$$

so ergeben sich der erste und zweite Generatorteil GT1, GT2 zu

$$GT1 = \begin{bmatrix} 1 & 0 & 0 & 0 \\ 0 & 1 & 0 & 0 \\ 0 & 0 & 1 & 0 \\ 0 & 0 & 0 & 1 \end{bmatrix} \text{ und} \tag{25}$$

$$GT2 = \begin{bmatrix} 0 & 1 & 1 & 1 \\ 1 & 0 & 1 & 1 \\ 1 & 1 & 0 & 1 \end{bmatrix}, \tag{26}$$

wobei der erste Generatorteil GT1 einer Einheitsmatrix entspricht.

c) Die Koeffizienten des zweiten Generatorteils GT2 werden in die Codiermatrix CM kopiert. Nach diesem Verarbeitungsschritt ergibt sich die Codiermatrix CM zu:

$$CM = \begin{bmatrix} & GN & & \\ 0 & 1 & 1 & 1 \\ 1 & 0 & 1 & 1 \\ 1 & 1 & 0 & 1 \end{bmatrix} \tag{27}$$

d) An den zweiten Generatorteil GT2 wird rechts in der Codiermatrix CM eine Einheitsmatrix E1 anhängt, wobei ein Rang der Einheitsmatrix E1 einer Zeilenanzahl des zweiten Generatorteils GT2 entspricht. Damit sieht die Codiermatrix CM wie folgt aus:

$$CM = \begin{bmatrix} & & & GN & & & \\ 0 & 1 & 1 & 1 & 1 & 0 & 0 \\ 1 & 0 & 1 & 1 & 0 & 1 & 0 \\ 1 & 1 & 0 & 1 & 0 & 0 & 1 \end{bmatrix} = \begin{bmatrix} & GN & \\ GT2 & E1 \end{bmatrix} \qquad (28)$$

In dieser Variante entspricht die Anzahl L der Zwischensymbole der Anzahl der codierten Symbole I.

Die Schritte a) bis d) dieser Variante werden als Schritt S32 bezeichnet und können im Schritt S22 gemäß Figur 2 zusätzlich ausgeführt werden. Nach Durchführung des Schritts S32 wird durch Schritt S23 die erste M1 erzeugt. Hierbei ist zu beachten, dass in die erste Matrix M1 zusätzlich diejenigen Zeilen der Codiermatrix CM kopiert werden, die den zweiten Generatorteil GT2 und die Einheitsmatrix E1 umfassen. Die weiteren Verarbeitungsschritte S24 bis S31 gemäß Figur 2 werden dann zur Ermittlung der Indizes der zu übertragenden Fehlerkorrektursymbole FKS durchgeführt.

In einer weiteren Variante ist das erfindungsgemäße Verfahren bei Verwendung mehrerer systematischer Blockcodes BC1, BC2 und einem diesen nachfolgenden nicht-systematischen Blockcode BCN verwendbar. In Figur 5 werden aus den Quellensymbolen Q mit Hilfe einer zweiten Generatormatrix G2 des zweiten systematischen Blockcodes BC2 erste Zwischensymbole I1, und aus den ersten Zwischensymbolen I1 mit Hilfe einer zweiten Generatormatrix G2 des zweiten systematischen Blockcodes BCs zweite Zwischensymbole I2 erzeugt. Die zweiten Zwischensymbole I2 werden unter Verwendung einer nicht-systematischen Generatormatrix GN eines nicht-systematischen Blockcodes BCN verarbeitet, so dass codierte Codesymbole CC generiert werden.

Für die Generierung der Codiermatrix CM werden in einem Schritt S33 gemäß Figur 2 folgende Verarbeitungsschritte durchgeführt:

a) Für den systematischen Blockcode BC1, welcher dem nicht-systematischen Blockcode BCN direkt vorausgeht, und den nicht-systematischen Blockcode BCN wird die Codiermatrix CM nach Schritt S32 gemäß Figur 2 ausgeführt. Die hierbei generierte Codiermatrix CM lautet:

$$CM = \begin{bmatrix} & GN & \\ GT2(G1) & E1 \end{bmatrix} \qquad (29)$$

Hierbei entspricht ein zweiter Generatorteil GT2(G1) demjenigen Bereich der ersten Generatormatrix G1, der die Paritätssymbole, d.h. die nicht-systematischen Symbole, der zweiten Zwischensymbole I2 erzeugt. Der Rang einer ersten Einheitsmatrix E1 ist identisch zur Zeilenanzahl des zweiten Generatorteil GT2(G1) der ersten Generatormatrix G1.

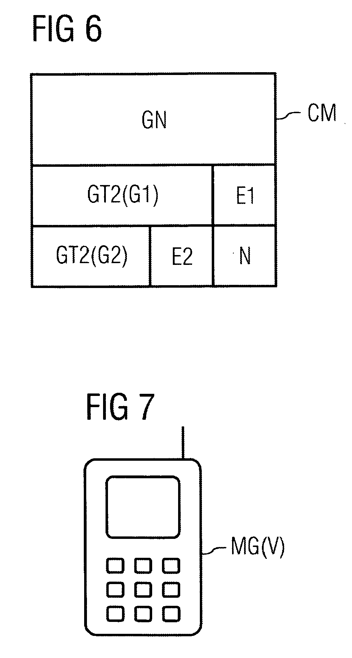

b) Der dem ersten systematischen Blockcode BC1 vorausgehende zweite systematische Blockcode BC2 wird gemäß Figur 6 in folgenden Teilschritten in die Codiermatrix CM einfügt:

- aus der zweiten Generatormatrix G2 wird derjenige zweite Generatorteil GT2 (G1) extrahiert, der die Paritätssymbole, d.h. die nicht-systematischen Symbole, der ersten Zwischensymbole I1 erzeugt;

- dieser extrahierte zweite Generatorteil GT2(G2) wird zeilenweise an das Ende der Codiermatrix CM kopiert;

- rechts des kopierten, zweiten Generatorteils GT2(G2) der zweiten Generatormatrix G2 wird eine zweite Einheitsmatrix E2 eingefügt, wobei der Rang dieser zweiten Einheitsmatrix E2 einer Zeilenanzahl des kopierten zweiten Generatorteils GT2(G2) der zweiten Generatormatrix G2 entspricht;

- rechts der eingefügten zweiten Einheitsmatrix M2 werden die, aufgrund einer Zeilenlänge der nicht-systematischen Generatormatrix GN, unbelegten Koeffizienten mit Null belegt. Dies ist in Figur 6 mit einem Bezugszeichen N markiert.

Somit ergibt sich gemäß dieser Erweiterung des erfindungsgemäßen Verfahrens die Codiermatrix CM zu:

$$CM = \begin{bmatrix} & GN & \\ GT2(G1) & & E1 \\ GT2(G2) & E2 & N \end{bmatrix} \qquad (30)$$

Diese zusätzlichen Schritte sind in Figur 2 mit dem Verarbeitungsschritt S33 gekennzeichnet und werden vor Schritt S23 ausgeführt.

Im Folgenden wird die erste Matrix M1 gemäß Schritt S23 erzeugt. Dabei ist zu beachten, dass in die erste Matrix M1 zusätzlich alle Zeilen der Codiermatrix CM eingefügt werden, die den zweiten Generatorteil G2(G1) der ersten Generatormatrix G1 und den zweiten Generatorteil G2(G1) der zweiten Generatormatrix G2 umfassen. Die Anzahl L der Zwischensymbole ist in dieser Variante durch die Summe der Anzahl der Quellensymbole Q, der Anzahl der Paritätssymbole am Ausgang des ersten systematischen Blockcodes BC1, und der Anzahl der Paritätssymbole am Ausgang des zweiten systematischen Blockcodes (BC2) spezifiziert. Die weiteren Verarbeitungsschritte S23 bis S31 gemäß Figur 2 werden dann zur Ermittlung der Indizes der zu übertragenden Fehlerkorrektursymbole FKS durchgeführt.

Das erfindungsgemäße Verfahren ist geeignet um bei einem systematischen oder nicht-systematischen Raptor-Code eine minimale Anzahl von anzufordernden Fehlerkorrektursymbolen FKS zu ermitteln. Dabei entspricht, wie in Figur 6 wiedergegeben, der nicht-systematische Blockcode BCN dem inneren Code des Raptor-Codes und der erste und zweite Blockcode BC1, BC2 den jeweiligen äußeren Codes des Raptor-Codes. Der innere Code ist auch als LT-Code (LT - Luby Transform) bekannt. Zusätzlich kann bei nicht-systematischen Raptor-Codes eine Korrekturmatrix G0 eines nicht-systematischen Blockcodes BC0 vor den zweiten systematischen Blockcode BC2 zum Erstellen von systematischen codierten Symbolen CC eingefügt werden. Dadurch entsteht ein systematischer Raptor-Code und es können systematisch codierte Codesymbole CC als Fehlerkorrektursymbole angefordert werden.

Das erfindungsgemäße Verfahren ist anhand von binären Symbolen beschrieben worden. Im Allgemeinen kann das erfindungsgemäße Verfahren mit binären Werten oder Werten eines Galois-Felds GF, wie z.B. im Galois-Feld $(2^8)$, benutzt werden.

Das erfindungsgemäße Verfahren ist unter Verwendung mehrerer Matrizen beschrieben worden. Im Allgemeinen kann das erfindungsgemäße Verfahren mit einer geringen Anzahl an Matrizen und mit zumindest einer anderen Reihenfolge der Schritte S22 bis S31 ausgeführt werden.

Das erfindungsgemäße Verfahren ist mit einer Vorrichtung V durchführbar, wobei die Empfangseinheit EE den Schritt S21, ein erstes Mittel ML1 der Schritt S22 und optional die Schritte S32 und S33, ein zweites Mittel ML2 den Schritt S23, ein drittes Mittel ML3 den Schritt S24, ein viertes Mittel ML4 den Schritt S25, ein fünftes Mittel ML5 den Schritt S26, ein sechstes Mittel ML6 den Schritt 27, ein siebtes Mittel ML7 den Schritt S28 und ein achtes Mittel ML8 den Schritt 29, ein neuntes Mittel ML9 den Schritt S30 und ein zehntes Mittel ML10 den Schritt S31 implementiert und ausführt. Ferner kann die Vorrichtung noch über ein elftes Mittel ML11 verfügen, mit dem Erweiterungen des erfindungsgemäßen Verfahrens realisierbar sind.

Das erfindungsgemäße Verfahren wird in einem Endgerät EG mit Hilfe der Vorrichtung V durchgeführt. In Figur 7 ist ein derartiges Endgerät EG in Form eines tragbaren Geräts abgebildet. Dieses tragbare Gerät arbeitet bspw. nach einem Mobilfunkstandard, insbesondere nach GSM-Standard (GSM-Global System für Mobile Communications), UMTS-Standard (UMTS-Universal Mobile Telecommunications System), DAB-Standard (DAB-Digital Audio Broadcast) oder DVB-Standard (DVB-Digital Video Broadcast) .

Literaturverzeichnis

[1] Prof. C. Preston, "Ein Skript für Lineare Algebra I und II", 2003/04, http://dhcp24-159.mathematik.uni-bielefeld.de/ ~preston/files/teaching/linalg/skripten/ linalg.pdf

**Patentansprüche**

**1.** Verfahren zum Ermitteln von Fehlerkorrektursymbolen (FKS) zugeordneten Indizes (ZI), wobei codierte Codesymbole (CC) unter Verwendung einer Generatormatrix (G) eines Blockcodes (BC) aus Quellensymbolen der Anzahl (K) generiert und die codierten Codesymbole (CC) von einer Sendevorrichtung (SV) zu einer Empfangsvorrichtung (EV) übertragen werden, wobei Übertragungsfehler (UEF) in den empfangenen Codesymbolen (C) auftreten, wobei die Indizes der zu übertragenden Fehlerkorrektursymbole (FKS) ermittelt werden, **gekennzeichnet durch** folgende Schritte:

a) ein größter Index (ZI) aller empfangenen Codesymbole (C) wird ermittelt,
b) ein erster Parameter (Rmin) wird festgelegt, der einen Wert aufweist, der größer als der größte Index (SI) aller empfangenen Codesymbole (C) ist,
c) eine erste Matrix (M1) wird zeilenweise aus einer von der Generatormatrix (G) abgeleiteten Codiermatrix (CM) derart gebildet, dass die i-te Zeile der Codiermatrix (CM) in die erste Matrix (M1) für ein fehlerfrei empfangenes i-tes Codiersymbol (C) kopiert wird,
d) jede Spalte der ersten Matrix (M1) wird mit einem Spaltenindex (SI) entsprechend einer Spaltennummer der Codiermatrix (CM) markiert,
e) die erste Matrix (M1) wird **durch** elementare Zeilenumformungen und/oder Spaltentausch in eine zweite Matrix (M2) mit RG unabhängigen Zeilen (ZU) transformiert, wobei RG einem Rang (RG) der zweiten Matrix (M2) entspricht,
f) ein zweiter Parameter (Rmax) wird nach der Formel

$$Rmax = Rmin + m - 1$$

ermittelt, wobei ein dritter ganzzahliger Parameter (m) aus der Differenz der Anzahl (L) an Zwischensymbolen und dem Rang (RG) der zweiten Matrix (M2) nach der Formel

$$m \leq L - RG(M2)$$

bestimmt wird,
g) ein vierter Parameter (R) wird gleich dem zweiten Parameter (Rmin) zu R = Rmin gesetzt,
h) eine dritte Matrix (M3) wird zeilenweise aus der zweiten Matrix (M2) und aus der von der Generatormatrix (G) abgeleiteten Codiermatrix (CM) derart gebildet, dass alle Zeilen zwischen einschließlich der R-ten und einschließlich der Rmax-ten der Codiermatrix (CM) in die dritte Matrix (M3) kopiert werden, wobei das Kopieren die Durchführung der zur Bildung der zweiten Matrix (M2) vorgenommenen Spaltenvertauschungen für die zu kopierenden Zeilen umfasst,
i) die dritte Matrix (M1) wird **durch** elementare Zeilenumformungen und/oder Spaltentausch in eine vierte Matrix (M4) mit RH unabhängigen Zeilen (ZH) transformiert, wobei RH einem Rang (RH) der vierten Matrix (M4) entspricht,
j) wenn die vierte Matrix (M4) keinen vollen Rang (RH) aufweist:

- der vierte Parameter (R) wird zu R = Rmax gesetzt,
- ein fünfter Parameter (n) wird ermittelt, der aus der Differenz der Anzahl (L) an Zwischensymbolen und dem Rang (RG) der vierten Matrix (M4) nach der Formel

$$n \leq L - RG(M4)$$

ermittelt wird,
- der zweite Parameter (Rmax) wird zu Rmax = Rmax + n gesetzt, und
- es werden die Schritte h) bis i) wiederholt, wobei anstatt der zweiten Matrix (M2) die vierte Matrix (M4) verwendet wird,

k) wenn die vierte Matrix (M4) einen vollen Rang (RH) aufweist:

**durch** den ersten und den zweiten Parameter (Rmin, Rmax) wird ein Bereich an codierten Codesymbolen (CC) eindeutig identifiziert, der in Form zumindest eines Fehlerkorrektursymbols (FKS) **durch** die Empfangsvorrichtung (EV) zur fehlerfreien Rekonstruktion der Quellensymbole (Q) von der Sendevorrichtung (SV) anforderbar ist.

2. Verfahren nach Anspruch 1,
**dadurch gekennzeichnet, dass**
die Zwischensymbole den Quellensymbolen (Q) entsprechen und die Anzahl (L) der Zwischensymbole der Anzahl der Quellensymbole (K) entspricht.

3. Verfahren nach Anspruch 1 oder 2,
**dadurch gekennzeichnet, dass**
der fünfte Parameter (n) auf 1 gesetzt wird.

4. Verfahren nach einem der vorhergehenden Ansprüche,
**dadurch gekennzeichnet, dass**
der dritte Parameter (m) eine beliebige ganzzahlige Zahl zwischen 1 und der Differenz der Anzahl (L) an Zwischensymbolen und dem Rang (RG) der zweiten Matrix (M2) ist.

5. Verfahren nach einem der vorhergehenden Ansprüche,
**dadurch gekennzeichnet, dass**
der fünfte Parameter (n) eine beliebige ganzzahlige Zahl zwischen 1 und der Differenz der Anzahl (L) an Zwischensymbolen und dem Rang (RG) der vierten Matrix (M4) ist.

6. Verfahren nach einem der vorhergehenden Ansprüche,
**dadurch gekennzeichnet, dass**
die Quellensymbole (Q) zuerst mit einer ersten Generatormatrix (G1) eines ersten systematischen Blockcode (BC1) und die hieraus codierten Symbole (I) mit einer nicht-systematischen Generatormatrix (GN) eines nicht-systematischen Blockcodes (BCN) codiert werden, wobei die Codiermatrix (CM) durch folgende Schritte erzeugt wird:

a) Die nicht-systematische Generatormatrix (GN) wird zeilenweise in die Codiermatrix (CM) kopiert;
b) Die erste Generatormatrix (G1) wird aufgeteilt in einen ersten Generatorteil (GT1), der die Quellensymbole (Q) erzeugt, und in einen zweiten Generatorteil (GT2), der die Paritätssymbole (P) erstellt;
c) Die Koeffizienten des zweiten Generatorteils (GT2) werden zeilenweise unterhalb der nicht-systematischen Generatormatrix (GN) in die Codiermatrix (CM) kopiert.
d) An den zweiten Generatorteil (GT2) wird rechts in der Codiermatrix (CM) eine erste Einheitsmatrix (E1) anhängt, wobei ein Rang der Einheitsmatrix (E1) einer Zeilenanzahl des zweiten Generatorteils (GT2) entspricht.

zusätzlich die Zeilen der Codiermatrix (CM), die den zweiten Generatorteil (GT2) und die Einheitsmatrix (E1) umfassen, zeilenweise in die erste Matrix (M1) kopiert werden, und die Anzahl (L) der Zwischensymbole der Anzahl der codierten Symbole (I) entspricht.

7. Verfahren nach einem der vorhergehenden Ansprüche,
**dadurch gekennzeichnet, dass**
für mehrere systematische Blockcodes (BC1, BC2) mit einer ersten und zweiten Generatormatrix (G1, G2), die vor einem nicht-systematischen Blockcode (BCN) mit einer nicht-systematischen Generatormatrix (GN) ausgeführt werden, folgende Schritte zur Erstellung der Codiermatrix (CM) durchgeführt werden:

a) Für die erste Generatormatrix (G1) des zweiten systematischen Blockcodes (BC1), welcher direkt vor dem nicht-systematischen Blockcode (BCN) ausgeführt wird, und für die nicht-systematische Generatormatrix (GN) wird gemäß Anspruch 6 die Codiermatrix (CM) ermittelt;
b) Die zweite Generatormatrix (G2) des zweiten systematischen Blockcodes (BC2), der vor dem ersten systematischen Blockcode (BC1) ausgeführt wird, wird derart in die Codiermatrix (CM) einfügt, dass

- aus der zweiten Generatormatrix (G2) derjenige zweite Generatorteil (GT2(G2)) extrahiert wird, der die Paritätssymbole am Ausgang des zweiten systematischen Blockcodes (BC2) erzeugt,
- dieser extrahierte zweite Generatorteil (GT2(G2)) zeilenweise an das Ende der Codiermatrix (CM) kopiert wird,
- rechts des kopierten zweiten Generatorteils (GT2(G2)) wird eine zweite Einheitsmatrix (E2) eingefügt, wobei der Rang dieser zweiten Einheitsmatrix (E2) einer Zeilenanzahl des kopierten zweiten Generatorteils (GT2(G2)) entspricht,

- rechts der eingefügten zweiten Einheitsmatrix (E2) die, aufgrund einer Zeilenlänge der nicht-systematischen Generatormatrix (GN), unbelegten Koeffizienten (N) mit Null belegt werden.

zusätzlich die Zeilen der Codiermatrix (CM), die den zweiten Generatorteil (GT2(G1)) der ersten Generatormatrix (G1) den zweiten Generatorteil (GT2(G1)) der zweiten Generatormatrix (G2) umfassen, zeilenweise in die erste Matrix (M1) kopiert werden und die Zwischensymbole (L) durch die Summe der Anzahl der Quellensymbole (Q), der Anzahl der Paritätssymbole am Ausgang des ersten systematischen Blockcodes (BC1), und der Anzahl der Paritätssymbole am Ausgang des zweiten systematischen Blockcodes (BC2) spezifiziert ist.

8. Verfahren nach Anspruch 7,
   **dadurch gekennzeichnet, dass**
   ein nicht-systematischer Raptorcode eingesetzt wird, wobei der erste und zweite systematische Blockcode (BC1, BC2) jeweils einem der äußeren Codes, und der nicht-systematische Blockcode (BCN) dem inneren Code des Raptorcodes entspricht.

9. Verfahren nach Anspruch 7,
   **dadurch gekennzeichnet, dass**
   ein systematischer Raptorcode eingesetzt wird, bei dem

   - der erste und zweite systematische Blockcode (BC1, BC2) jeweils einem der äußeren Codes, und der nicht-systematische Blockcode (BCN) dem inneren Code des Raptorcodes entspricht
   - eine Korrekturmatrix (G0) eines nicht-systematischen Blockcodes (BC0) vor den zweiten systematischen Blockcode (BC2) zum Erstellen von systematischen codierten Symbolen (CC) eingefügt wird.

10. Verfahren nach Anspruch 1,
    **dadurch gekennzeichnet, dass**
    als Blockcode (BC) ein nicht-systematischer Blockcode verwendet wird,
    die Codematrix (CM) durch Kopieren der Generatormatrix (G) erstellt wird.

11. Verfahren nach Anspruch 1,
    **dadurch gekennzeichnet, dass**
    als Blockcode (BC) ein systematischer Blockcode verwendet wird,
    die Codematrix (CM) durch Kopieren der Generatormatrix (G) erstellt wird.

12. Verfahren nach einem der vorhergehenden Ansprüche,
    **dadurch gekennzeichnet, dass**
    den Quellensymbolen (Q), codierten Codesymbolen (CC) und den Codesymbolen (C) binäre Werte oder Werte eines Galois-Felds (GF) zugewiesen werden.

13. Vorrichtung (V) zum Durchführen eines Verfahren zum Ermitteln von Fehlerkorrektursymbolen (FKS), wobei codierte Codesymbole (CC) unter Verwendung einer Generatormatrix (G) eines Blockcodes (BC) aus Quellensymbolen der Anzahl (K) generiert und die codierten Codesymbole (CC) von einer Sendevorrichtung (SV) zu einer Empfangsvorrichtung (EV) übertragen werden, wobei Übertragungsfehler (UEF) in den empfangenen Codesymbolen (C) auftreten, wobei die Indizes der zu übertragenden Fehlerkorrektursymbole (FKS) ermittelt werden,
    **gekennzeichnet durch**:

    a) ein erstes Mittel (ML1) zum Ermitteln eines größten Index (SI) aller empfangenen Codesymbole (C),
    b) ein zweites Mittel (ML2) zum Festlegen eines ersten Parameters (Rmin), der einen Wert aufweist, der größer als der größte Index aller empfangenen Codesymbols (C) ist,
    c) ein drittes Mittel (ML3) zum zeilenweisen Bilden einer ersten Matrix (M1) aus einer von der Generatormatrix (G) abgeleiteten Codiermatrix (CM), wobei die i-te Zeile der Codiermatrix (CM) in die erste Matrix (M1) für ein fehlerfrei empfangenes i-tes Codiersymbol (C) kopiert wird,
    d) ein viertes Mittel (ML4) zum Markieren jeder Spalte der ersten Matrix (M1) mit einem Spaltenindex (SI) entsprechend einer Spaltennummer der Codiermatrix (CM),
    e) ein fünftes Mittel (ML5) zum Transformieren der ersten Matrix (M1) **durch** elementare Zeilenumformungen und/oder Spaltentausch in eine zweite Matrix (M2) mit RG unabhängigen Zeilen (ZU), wobei RG einem Rang (RG) der zweiten Matrix (M2) entspricht,
    f) ein sechstes Mittel (ML6) zum Ermitteln eines zweiten Parameters (Rmax) nach der Formel

$$Rmax = Rmin + m - 1,$$

**durch** das ein dritter Parameter (m) aus der Differenz der Anzahl an Zwischensymbolen (L) und dem Rang (RG) der zweiten Matrix (M2) nach der Formel

$$m \leq L - RG(M2)$$

ermittelt wird, und **durch** das ein vierter Parameter (R) gleich dem zweiten Parameter (Rmin) zu R = Rmin gesetzt wird,

g) ein siebtes Mittel (ML7) zum zeilenweise Bilden einer dritten Matrix (M3) aus der zweiten Matrix (M2) und aus der von der Generatormatrix (G) abgeleiteten Codiermatrix (CM), dass alle Zeilen zwischen einschließlich der R-ten und einschließlich der Rmax-ten der Codiermatrix (CM) in die dritte Matrix (M3) kopiert werden, wobei das Kopieren die Durchführung der zur Bildung der zweiten Matrix (M2) vorgenommenen Spaltenvertauschungen für die zu kopierenden Zeilen umfasst,

h) ein achtes Mittel (ML8) zum Transformieren der dritten Matrix (M1) **durch** elementare Zeilenumformungen und/oder Spaltentausch in eine vierte Matrix (M4) mit RH unabhängigen Zeilen (ZH), wobei RG einem Rang (RG) der vierten Matrix (M4) entspricht,

i) ein neuntes Mittel (ML9) zum Überprüfen, ob die vierte Matrix (M4) einen vollen Rang (RH) aufweist oder nicht, das dazu ausgebildet ist, folgende Schritte durchzuführen, wenn die vierte Matrix (M4) keinen vollen Rang (RH) aufweist:

- den vierten Parameter (R) zu R = Rmax zu setzen,
- einen fünften Parameter (n) zu ermitteln, der aus der Differenz der Anzahl (L) an Zwischensymbolen und dem Rang (RG) der vierten Matrix (M4) nach der Formel

$$n \leq L - RG(M4)$$

bestimmt wird,
- den zweiten Parameter (Rmax) zu Rmax = Rmax + n zu setzen, und
- die Wiederholung der Schritte g) bis h) zu veranlassen, wobei anstatt der zweiten Matrix (M2) die vierte Matrix (M4) verwendet wird,

j) ein zehntes Mittel (ML10), das dazu ausgebildet ist, folgende Schritte durchzuführen, wenn die vierte Matrix (M4) einen vollen Rang (RH) aufweist:

eindeutiges Identifizieren eines Bereichs an codierten Codesymbolen (CC)durch den ersten und den zweiten Parameter (Rmin, Rmax), wobei das codierte Codesymbol (CC) in Form zumindest eines Fehlerkorrektursymbols (FKS) **durch** die Empfangsvorrichtung (EV) zur fehlerfreien Rekonstruktion der Quellensymbole (Q) angefordert und von der Sendevorrichtung (SV) übertragen wird.

**14.** Vorrichtung (V) nach Anspruch 13,
**gekennzeichnet durch**
ein elftes Mittel (ML11), welches derart ausgestaltet ist, dass ein Verfahren gemäß einem der Ansprüche 2 bis 10 mittels der Vorrichtung (V) durchführbar ist.

**15.** Endgerät (EG), insbesondere ein tragbares Gerät nach einem Mobilfunkstandard, insbesondere nach GSM-Standard, UMTS-Standard oder DVB-Standard,
**gekennzeichnet dadurch, dass**
in das Endgerät (EG) eine Vorrichtung (V) nach Anspruch 13 oder 14 integriert ist.

**Claims**

1. A method for determining indexes (ZI) assigned to error correcting symbols (FKS), wherein encoded code symbols (CC) are generated from source symbols of the number (K) using a generator matrix (G) of a block code (BC) and the encoded code symbols (CC) are transmitted by a transmitting device (SV) to a receiving device (EV), wherein transmission errors (UEF) occur in the received code symbols (C), wherein the indexes of the error correcting symbols (FKS) that have to be transmitted are determined, **characterised by** the following steps:

   a) a greatest index (ZI) of all received code symbols (C) is determined,
   b) a first parameter (Rmin) is defined which has a value greater than the greatest index (SI) of all received code symbols (C),
   c) a first matrix (M1) is formed line by line from a coding matrix (CM) derived from the generator matrix (G) such that the i-th line of the coding matrix (CM) is copied to the first matrix (M1) for a correctly received i-th code symbol (C),
   d) each column of the first matrix (M1) is marked with a column index (SI) corresponding to a column number of the coding matrix (CM),
   e) the first matrix (M1) is transformed by elementary line transformations and/or column transposition into a second matrix (M2) with RG independent lines (ZU), where RG is a row (RG) of the second matrix (M2),
   f) a second parameter (Rmax) is determined by the formula

$$\text{Rmax} = \text{Rmin} + m - 1$$

   with a third integer parameter (m) being determined from the difference of the number (L) of intermediate symbols and the row (RG) of the second matrix (M2) according to the formula

$$m \leq L - RG(M2)$$

   g) a fourth parameter (R) is set equal to the second parameter (Rmin) as R = Rmin,
   h) a third matrix (M3) is formed line by line from the second matrix (M2) and from the coding matrix (CM) derived from the generator matrix (G) such that all lines between the R-th inclusive and the Rmax-th inclusive of the coding matrix (CM) are copied into the third matrix (M3), wherein the copying includes the performing of the column transpositions for the lines that have to be copied that are carried out to form the second matrix (M2),
   i) the third matrix (M1) is transformed by elementary line transformations and/or column transposition into a fourth matrix (M4) with RH independent lines (ZH), where RH is a row (RH) of the fourth matrix (M4),
   j) if the fourth matrix (M4) does not have a full row (RH):

   - the fourth parameter (R) is set to R = Rmax,
   - a fifth parameter (n) is determined which is determined from the difference of the number (L) of intermediate symbols and the row (RG) of the fourth matrix (M4) according to the formula

$$n \leq L - RG(M4)$$

   - the second parameter (Rmax) is set to Rmax = Rmax + n, and
   - steps h) to i) are repeated, with the fourth matrix (M4) being used instead of the second matrix (M2),

   k) if the fourth matrix (M4) has a full row (RH):

   the first and the second parameter (Rmin, Rmax) uniquely identify a range of encoded code symbols (CC) that can be requested by the receiving device (EV) from the transmitting device (SV) in the form of at least one error correcting symbol (FKS) for the error-free reconstruction of the source symbols (Q).

2. A method according to claim 1,

**characterised in that**
the intermediate symbols correspond to the source symbols (Q) and the number (L) of intermediate symbols corresponds to the number of source symbols (K).

3. A method according to claim 1 or 2,
**characterised in that**
the fifth parameter (n) is set to 1.

4. A method according to any one of the preceding claims,
**characterised in that**
the third parameter (m) is any whole number between 1 and the difference of the number (L) of intermediate symbols and the row (RG) of the second matrix (M2).

5. A method according to any one of the preceding claims,
**characterised in that**
the fifth parameter (n) is any whole number between 1 and the difference of the number (L) of intermediate symbols and the row (RG) of the fourth matrix (M4).

6. A method according to any one of the preceding claims,
**characterised in that**
the source symbols (Q) are first encoded with a first generator matrix (G1) of a first systematic block code (BC1) and the symbols (I) encoded therefrom are encoded with a non-systematic generator matrix (GN) of a non-systematic block code (BCN), wherein the coding matrix (CM) is generated by the following steps:

a) The non-systematic generator matrix (GN) is copied line by line to the coding matrix (CM);
b) The first generator matrix (G1) is divided into a first generator part (GT1) which generates the source symbols (Q), and a second generator part (GT2) which creates the parity symbols (P);
c) The coefficients of the second generator part (GT2) are copied line by line beneath the non-systematic generator matrix (GN) into the coding matrix (CM).
d) An identity matrix (E1) is appended to the second generator part (GT2) on the right in the coding matrix (CM), whereby a row of the identity matrix (E1) corresponds to a number of lines of the second generator part (GT2).

additionally the lines of the coding matrix (CM) which comprise the second generator part (GT2) and the identity matrix (E1) are copied line by line into the first matrix (M1), and the number (L) of intermediate symbols equals the number of encoded symbols (I).

7. A method according to any one of the preceding claims,
**characterised in that**
for a plurality of systematic block codes (BC1, BC2) having a first and second generator matrix (G1, G2) and which are executed before a non-systematic block code (BCN) with a non-systematic generator matrix (GN), the following steps are performed to create the coding matrix (CM):

a) For the first generator matrix (G1) of the second systematic block code (BC1) which is executed directly before the non-systematic block code (BCN), and for the non-systematic generator matrix (GN), the coding matrix (CM) is determined according to claim 6;
b) The second generator matrix (G2) of the second systematic block code (BC2) which is executed before the first systematic block code (BC1) is inserted into the coding matrix (CM) such that

- the second generator part (GT2(G2)) which generates the parity symbols at the output of the second systematic block code (BC2) is extracted from the second generator matrix (G2),
- this extracted second generator part (GT2(G2)) is copied line by line to the end of the coding matrix (CM),
- a second identity matrix (E2) is inserted to the right of the copied second generator part (GT2(G2)), whereby the row of this second identity matrix (E2) corresponds to a number of lines of the copied second generator part (GT2(G2)),
- to the right of the inserted second identity matrix (E2) the coefficients (N) that are unassigned because of a line length of the non-systematic generator matrix (GN) are assigned zero,

additionally the lines of the coding matrix (CM) which comprise the second generator part (GT2(G1)) of the first generator matrix (G1) the second generator part (GT2(G1)) of the second generator matrix (G2) *[sic]* are copied line by line into the first matrix (M1) and the intermediate symbols (L) is *[sic]* specified by the sum of the number of source symbols (Q), the number of parity symbols at the output of the first systematic block code (BC1) and the number of the parity symbols at the output of the second systematic block code (BC2).

8. A method according to claim 7,
   **characterised in that**
   a non-systematic Raptor code is used, whereby the first and second systematic block code (BC1, BC2) each correspond to one of the outer codes, and the non-systematic block code (BCN) corresponds to the inner code of the Raptor code.

9. A method according to claim 7,
   **characterised in that**
   a systematic Raptor code is used, in which

   - the first and second systematic block code (BC1, BC2) each correspond to one of the outer codes, and the non-systematic block code (BCN) corresponds to the inner code of the Raptor code
   - a correcting matrix (G0) of a non-systematic block code (BC0) is inserted before the second systematic block code (BC2) to create systematic encoded symbols (CC).

10. A method according to claim 1,
    **characterised in that**
    a non-systematic block code is used as block code (BC),
    the code matrix (CM) is created by copying the generator matrix (G).

11. A method according to claim 1,
    **characterised in that**
    a systematic block code is used as block code (BC),
    the code matrix (CM) is created by copying the generator matrix (G).

12. A method according to any one of the preceding claims,
    **characterised in that**
    encoded code symbols (CC) are assigned to the source symbols (Q) and binary values or values of a Galois field (GF) are assigned to the code symbols (C).

13. A device (V) for performing a method for determining error correcting symbols (FKS), wherein encoded code symbols (CC) are generated from source symbols of the number (K) using a generator matrix (G) of a block code (BC) and the encoded code symbols (CC) are transmitted by a transmitting device (SV) to a receiving device (EV), wherein transmission errors (UEF) occur in the received code symbols (C), wherein the indexes of the error correcting symbols (FKS) that have to be transmitted are determined, **characterised by**:

    a) a first means (ML1) for determining a greatest index (SI) of all received code symbols (C),
    b) a second means (ML2) for defining a first parameter (Rmin) which has a value greater than the greatest index of all received code symbols (C).
    c) a third means (ML3) for the line-by-line forming of a first matrix (M1) from a coding matrix (CM) derived from the generator matrix (G), whereby the i-th line of the coding matrix (CM) is copied to the first matrix (M1) for a correctly received i-th code symbol (C),
    d) a fourth means (ML4) for the marking of each column of the first matrix (M1) with a column index (SI) corresponding to a column number of the coding matrix (CM),
    e) a fifth means (ML5) for transforming the first matrix (M1) by elementary line transformations and/or column transposition into a second matrix (M2) with RG independent lines (ZU), wherein RG corresponds to a row (RG) of the second matrix (M2),
    f) a sixth means (ML6) for determining a second parameter (Rmax) according to the formula

$$Rmax = Rmin + m - 1,$$

by which a third parameter (m) is determined from the difference of intermediate symbols (L) and the row (RG) of the second matrix (M2) according to the formula

$$m \leq L - RG(M2)$$

and by which a fourth parameter (R) is set equal to the second parameter (Rmin) to R = Rmin,

g) a seventh means (ML7) for the line-by-line forming of a third matrix (M3) from the second matrix (M2) and from the coding matrix (CM) derived from the generator matrix (G), that *[sic]* all lines between the R-th inclusive and the Rmax-th inclusive of the coding matrix (CM) are copied into the third matrix (M3), wherein the copying includes the performing of the column transpositions for the lines that have to be copied and that are carried out to form the second matrix (M2),

h) an eighth means (ML8) for transforming the third matrix (M1) by elementary line transformations and/or column transposition into a fourth matrix (M4) with RH independent lines (ZH), wherein RG corresponds to a row (RG) of the fourth matrix (M4),

i) a ninth means (ML9) for checking whether the fourth matrix (M4) exhibits a full row (RH) or not, and which is configured to perform the following steps when the fourth matrix (M4) does not exhibit a full row (RH):

- set the fourth parameter (R) to R = Rmax,
- determine a fifth parameter (n) which is determined from the difference of the number (L) of intermediate symbols and the row (RG) of the fourth matrix (M4) according to the formula

$$n \leq L - RG \ (M4)$$

- set the second parameter (Rmax) to Rmax = Rmax + n, and
- initiate the repetition of steps g) to h), with the fourth matrix (M4) being used instead of the second matrix (M2),

j) a tenth means (ML10) which is configured to perform the following steps when the fourth matrix (M4) exhibits a full row (RH): unique identification of a range of encoded code symbols (CC) by the first and the second parameter (Rmin, Rmax), with the encoded code symbol (CC) in the form of at least one error correcting symbol (FKS) being requested by the receiving device (EV) for the error-free reconstruction of the source symbols (Q) and being transmitted by the transmitting device (SV).

14. A device (V) according to claim 13,
**characterised by**
an eleventh means (ML11) which is embodied in such a way that a method according to any one of claims 2 to 10 can be performed by means of the device (V).

15. A terminal (EG), in particular a portable appliance according to a mobile radio standard, in particular GSM standard, UMTS standard or DVB standard,
**characterised in that**
the terminal (EG) incorporates a device (V) according to claim 13 or 14.

**Revendications**

1. Procédé pour déterminer des indices (ZI) affectés à des symboles de correction d'erreur (FKS), dans lequel des symboles de code codés (CC) sont générés en employant une matrice de générateur (G) d'un code de bloc (BC) à partir de symboles sources de nombre (K) et les symboles de code codés (CC) sont transmis d'un dispositif émetteur (SV) à un dispositif récepteur (EV), dans lequel des erreurs de transmission (UEF) apparaissent dans les symboles de code reçus (C), dans lequel on détermine les indices des symboles de correction d'erreur (FKS) à transmettre, **caractérisé par** les étapes suivantes consistant à :

a) déterminer un plus grand indice (ZI) de tous les symboles de code reçus (C),
b) définir un premier paramètre (Rmin) qui présente une valeur qui est supérieure au plus grand indice (SI) de tous les symboles de code reçus (C),

c) former une première matrice (M1) ligne par ligne à partir d'une matrice de codage (CM) déduite de la matrice de générateur (G) de manière telle que la $i^{ème}$ ligne de la matrice de codage (CM) soit copiée dans la première matrice (M1) pour un $i^{ème}$ symbole de codage (C) reçu sans erreur,

d) marquer chaque colonne de la première matrice (M1) par un indice de colonne (SI) correspondant à un numéro de colonne de la matrice de codage (CM),

e) transformer la première matrice (M1) par des transformations de ligne élémentaires et/ou un échange de colonne en une deuxième matrice (M2) ayant RG lignes indépendantes (ZU), RG correspondant à un rang (RG) de la deuxième matrice (M2),

f) déterminer un deuxième paramètre (Rmax) d'après la formule

$$Rmax = Rmin + m - 1,$$

un troisième paramètre entier (m) étant défini à partir de la différence du nombre (L) de symboles intermédiaires et du rang (RG) de la deuxième matrice (M2) selon la formule

$$m \leq L - RG(M2),$$

g) rendre égal un quatrième paramètre (R) au deuxième paramètre (Rmin) : R = Rmin,

h) former une troisième matrice (M3) ligne par ligne à partir de la deuxième matrice (M2) et de la matrice de codage (CM) déduite de la matrice de générateur (G) de manière telle que toutes les lignes entre la $R^{ème}$ ligne comprise et la $Rmax^{ème}$ ligne comprise de la matrice de codage (CM) soient copiées dans la troisième matrice (M3), l'opération de copie consistant à effectuer pour les lignes à copier des échanges de colonne réalisés pour la formation de la deuxième matrice (M2),

i) transformer la troisième matrice (M3) par des transformations de ligne élémentaires et/ou un échange de colonne en une quatrième matrice (M4) ayant RH lignes indépendantes (ZH), RH correspondant à un rang (RH) de la quatrième matrice (M4),

j) lorsque la quatrième matrice (M4) ne comporte pas de rang complet (RH) :

- définir le quatrième paramètre (R) tel que R = Rmax,
- déterminer un cinquième paramètre (n) à partir de la différence du nombre (L) de symboles intermédiaires et du rang (RG) de la quatrième matrice (M4) selon la formule

$$n \leq L - RG(M4),$$

- définir le deuxième paramètre (Rmax) tel que Rmax = Rmax + n, et
- répéter les étapes h) à i) en employant la quatrième matrice (M4) au lieu de la deuxième matrice (M2),

k) lorsque la quatrième matrice (M4) comporte un rang complet (RH) :

identifier univoquement par le biais des premier et deuxième paramètres (Rmin, Rmax) une zone de symboles de code codés (CC) qui peut être demandée sous forme d'au moins un symbole de correction d'erreur (FHS) par le dispositif récepteur (EV) à des fins de reconstruction sans erreurs des symboles sources (Q) par le dispositif émetteur (SV).

2. Procédé selon la revendication 1, **caractérisé en ce que** les symboles intermédiaires correspondent aux symboles sources (Q) et le nombre (L) des symboles intermédiaires correspond au nombre des symboles sources (K).

3. Procédé selon la revendication 1 ou 2, **caractérisé en ce que** le cinquième paramètre (n) est mis à 1.

4. Procédé selon l'une quelconque des revendications précédentes, **caractérisé en ce que** le troisième paramètre (m) est un nombre entier quelconque entre 1 et la différence du nombre (L) de symboles intermédiaires et du rang (RG) de la deuxième matrice (M2).

5. Procédé selon l'une quelconque des revendications précédentes, **caractérisé en ce que** le cinquième paramètre (n) est un nombre entier quelconque entre 1 et la différence du nombre (L) de symboles intermédiaires et du rang (RG) de la quatrième matrice (M4).

6. Procédé selon l'une quelconque des revendications précédentes, **caractérisé en ce que** les symboles sources (Q) sont d'abord codés avec une première matrice de générateur (G1) d'un premier code de bloc systématique (BC1) et les symboles codés en résultant (I) sont codés avec une matrice de générateur non systématique (GN) d'un code de bloc non systématique (BCN), la matrice de codage (CM) étant générée par les étapes suivantes consistant à :

   a) copier la matrice de générateur non systématique (GN) ligne par ligne dans la matrice de codage (CM) ;
   b) diviser la première matrice de générateur (G1) en une première partie génératrice (GT1), qui génère les symboles sources (Q), et en une deuxième partie génératrice (GT2) qui crée les symboles de parité (P) ;
   c) copier les coefficients de la deuxième partie génératrice (GT2) ligne par ligne en dessous de la matrice de générateur non systématique (GN) dans la matrice de codage (CM).
   d) adjoindre une première matrice unité (E1) à la deuxième partie génératrice (GT2) sur la droite dans la matrice de codage (CM), un rang de la matrice unité (E1) correspondant à un nombre de lignes de la deuxième partie génératrice (GT2),

   de plus copier les lignes de la matrice de codage (CM), qui comportent la deuxième partie génératrice (GT2) et la matrice unité (E1), ligne par ligne dans la première matrice (M1) et le nombre (L) des symboles intermédiaires correspondant au nombre des symboles codés (I).

7. Procédé selon l'une quelconque des revendications précédentes, **caractérisé en ce que** pour plusieurs codes de bloc systématiques (BC1, BC2) avec une première et une deuxième matrices de générateur (G1, G2), qui sont exécutés avant un code de bloc non systématique (BCN) avec une matrice de générateur non systématique (GN), on exécute les étapes suivantes pour créer la matrice de codage (CM) :

   a) pour la première matrice de générateur (G1) du deuxième code de bloc systématique (BC1), qui est exécuté directement avant le code de bloc non systématique (BCN), et pour la matrice de générateur non systématique (GN), on détermine la matrice de codage (CM) selon la revendication 6 ;
   b) la deuxième matrice de générateur (G2) du deuxième code de bloc systématique (BC2), qui est exécuté avant le premier code de bloc systématique (BC1), est introduite dans la matrice de codage (CM) de manière telle que

      - on extraie de la deuxième matrice de générateur (G2) la deuxième partie génératrice (GT2(G2)) qui génère les symboles de parité en sortie du deuxième code de bloc systématique (BC2),
      - on copie cette deuxième partie génératrice extraite (GT2(G2)) ligne par ligne à la fin de la matrice de codage (CM),
      - on introduise à droite de la deuxième partie génératrice copiée (GT2(G2)) une deuxième matrice unité (E2), le rang de cette deuxième matrice unité (E2) correspondant à un nombre de lignes de la deuxième partie génératrice (GT2(G2)),
      - à droite de la deuxième matrice unité introduite (E2), on mette à zéro les coefficients (N) non définis en raison d'une longueur de ligne de la matrice de générateur non systématique (GN),

   en plus, les lignes de la matrice de codage (CM), qui comportent la deuxième partie génératrice (GT2(G1)) de la première matrice de générateur (G1) et la deuxième partie génératrice (GT2(G1)) de la deuxième matrice de générateur (G2), sont copiées ligne par ligne dans la première matrice (M1) et le symbole intermédiaire (L) est spécifié par la somme du nombre des symboles sources (Q), du nombre des symboles de parité à la sortie du premier code de bloc systématique (BC1) et du nombre des symboles de parité à la sortie du deuxième code de bloc systématique (BC2).

8. Procédé selon la revendication 7, **caractérisé en ce que** l'on emploie un code raptor non systématique, les premier et deuxième codes de bloc systématiques (BC1, BC2) correspondant respectivement à un des codes externes et le code de bloc non systématique (BCN) correspondant au code interne du code raptor.

9. Procédé selon la revendication 7, **caractérisé en ce que** l'on emploie un code raptor systématique, avec lequel

- les premier et deuxième codes de bloc systématiques (BC1, BC2) correspondent respectivement à un des codes externes et le code de bloc non systématique (BCN) correspond au code interne du code raptor
- on introduit une matrice de correction (G0) d'un code de bloc non systématique (BC0) avant le deuxième code de bloc systématique (BC2) afin de créer des symboles codés systématiques (CC).

10. Procédé selon la revendication 1, **caractérisé en ce que** le code de bloc (BC) employé est un code de bloc non systématique,
la matrice de codage (CM) est créée par copie de la matrice de générateur (G).

11. Procédé selon la revendication 1, **caractérisé en ce que**
le code de bloc (BC) employé est un code de bloc systématique,
la matrice de codage (CM) est créée par copie de la matrice de générateur (G).

12. Procédé selon l'une quelconque des revendications précédentes, **caractérisé en ce que**
des symboles de code codés (CC) sont affectés aux symboles sources (Q) et des valeurs binaires ou des valeurs d'un champ de Galois (GF) sont affectées aux symboles de code (C).

13. Dispositif (V) permettant d'exécuter un procédé servant à déterminer des symboles de correction d'erreur (FKS), dans lequel des symboles de code codés (CC) sont générés en employant une matrice de générateur (G) d'un code de bloc (BC) à partir de symboles sources du nombre (K) et les symboles de code codés (CC) sont transmis d'un dispositif émetteur (SV) à un dispositif récepteur (EV), dans lequel des erreurs de transmission (UEF) apparaissent dans les symboles de code reçus (C), dans lequel les indices des symboles de correction d'erreur (FKS) à transmettre sont déterminés, **caractérisé par** :

a) un premier moyen (ML1) servant à déterminer un plus grand indice (SI) de tous les symboles de code reçus (C),
b) un deuxième moyen (ML2) servant à définir un premier paramètre (Rmin) qui présente une valeur qui est plus grande que le plus grand indice de tous les symboles de codes reçus (C),
c) un troisième moyen (ML3) servant à former ligne par ligne une première matrice (M1) à partir d'une matrice de codage (CM) déduite de la matrice de générateur (G), la $i^{ème}$ ligne de la matrice de codage (CM) étant copiée dans la première matrice (M1) pour un $i^{ème}$ symbole de codage (C) reçu sans erreur,
d) un quatrième moyen (ML4) servant à marquer chaque colonne de la première matrice (M1) avec un indice de colonne (SI) correspondant à un numéro de colonne de la matrice de codage (CM),
e) un cinquième moyen (ML5) servant à transformer la première matrice (M1) par des transformations de ligne élémentaires et/ou un échange de colonne en une deuxième matrice (M2) ayant RG lignes indépendantes (ZU), RG correspondant à un rang (RG) de la deuxième matrice (M2),
f) un sixième moyen (ML6) servant à déterminer un deuxième paramètre (Rmax) d'après la formule

$$Rmax = Rmin + m - 1,$$

par lequel un troisième paramètre (m) est déterminé à partir de la différence du nombre de symboles intermédiaires (L) et du rang (RG) de la deuxième matrice (M2) d'après la formule

$$m \leq L - RG(M2)$$

et par lequel un quatrième paramètre (R) est rendu égal au deuxième paramètre (Rmin) : R = Rmin,
g) un septième moyen (ML7) servant à former ligne par ligne une troisième matrice (M3) à partir de la deuxième matrice (M2) et à partir de la matrice de codage (CM) déduite de la matrice de générateur (G) de sorte que toutes les lignes entre la $R^{ème}$ ligne comprise et la $Rmax^{ème}$ ligne comprise de matrice de codage (CM) soient copiées dans la troisième matrice (M3), l'opération de copie consistant à effectuer pour les lignes à copier des échanges de colonne réalisés pour la formation de la deuxième matrice (M2),
h) un huitième moyen (ML8) servant à transformer la troisième matrice (M1) par des transformations de ligne élémentaires et/ou par un échange de colonne en une quatrième matrice (M4) ayant RH lignes indépendantes (ZH), RG correspondant à un rang (RG) de la quatrième matrice (M4),

i) un neuvième moyen (ML9) servant à vérifier si la quatrième matrice (M4) présente ou non un rang complet (RH), ledit moyen étant conçu pour exécuter les étapes suivantes lorsque la quatrième matrice (M4) ne comporte pas de rang complet (RH) :

- définir le quatrième paramètre (R) tel que R = Rmax,
- déterminer un cinquième paramètre (n) qui est déterminé à partir de la différence du nombre (L) de symboles intermédiaires et du rang (RG) de la quatrième matrice (M4) d'après la formule

$$n \leq L - RG(M4),$$

- définir le deuxième paramètre (Rmax) tel que Rmax = Rmax + n, et
- ordonner la répétition des étapes g) à h) en employant la quatrième matrice (M4) à la place de la deuxième matrice (M2),

j) un dixième moyen (ML10) qui est conçu pour exécuter les étapes suivantes lorsque la quatrième matrice (M4) comporte un rang complet (RH) : identifier univoquement une zone de symboles de code codés (CC) par les premier et deuxième paramètres (Rmin, Rmax), le symbole de code codé (CC) étant demandé sous forme d'au moins un symbole de correction d'erreur (FKS) par le dispositif récepteur (EV) à des fins de reconstruction sans erreurs des symboles sources (Q) et étant transmis par le dispositif émetteur (SV).

**14.** Dispositif (V) selon la revendication 13, **caractérisé par** un onzième moyen (ML11) qui est conçu de manière telle qu'un procédé selon l'une quelconque des revendications 2 à 10 puisse être exécuté par le dispositif (V).

**15.** Terminal (EG), en particulier un appareil portable selon une norme de radiocommunication mobile, en particulier la norme GSM, la norme UMTS ou la norme DVB, **caractérisé en ce qu'**un dispositif (V) selon la revendication 13 ou 14 est intégré dans le terminal (EG).

FIG 1

FIG 2

# FIG 3

Q →── BC1 [(G1)] ── I ── BCN [(GN)] ── CC →

# FIG 4

| GN | |
|---|---|
| GT2 | E1 |

── CM

# FIG 5

Q →── BC0 [(G0)] ── BC2 [(G2)] ── I1 ── BC1 [(G1)] ── I2 ── BCN [(GN)] ── CC →

FIG 6

| GN | | |
|---|---|---|
| GT2(G1) | | E1 |
| GT2(G2) | E2 | N |

CM

FIG 7

MG(V)

**IN DER BESCHREIBUNG AUFGEFÜHRTE DOKUMENTE**

**In der Beschreibung aufgeführte Nicht-Patentliteratur**

- Raptor code specification for MBMS file download. *3GPP SA4 PSM AD-HOC #31, XX, XX,* 21. Mai 2004, 1-8
- **STOCKHAMMER et al.** Raptor Codes for Reliable Download Delivery in Wireless Broadcast Systems. *CONSUMER COMMUNICATIONS AND NETWORKING CONFERENCE, 2006,* Januar 2006, ISBN 1-4244-0085-6, 1-6
- Universal Mobile Telecommunications System (UMTS); Multimedia Broadcast/Multicast Service (MBMS); user service guidelines. *ETSI TR 126 946 V6.0.1,* Marz 2006, 1-39, http://webapp.etsi.org/action/PU/ 20060613/tr_126946v060001p.pdf>
- **C. PRESTON.** *Ein Skript für Lineare Algebra I und II,* 2003, http://dhcp24-159.mathematik.uni-bielefeld.de/~preston/files/teaching/linalg/skripten/ linalg.pdf